# FASCICULE DE BREVET EUROPEEN

(11) **EP 2 030 230 B1**
(45) Date de publication et mention de la délivrance du brevet: **05.10.2011**
(21) Numéro de dépôt: 07788995.4
(22) Date de dépôt: 12.06.2007
(51) Int. Cl.: H01L 21/60, H01L 23/367, H01L 23/13

(54) **SUPPORT POUR COMPOSANT ELECTRIQUE ET DISPOSITIF ELECTRIQUE COMPRENANT LE SUPPORT ET LE COMPOSANT**
HALTER FÜR EINE ELEKTRISCHE KOMPONENTE UND ELEKTRISCHE VORRICHTUNG MIT DEM HALTER UND DER KOMPONENTE
HOLDER FOR ELECTRICAL COMPONENT AND ELECTRICAL DEVICE INCLUDING THE HOLDER AND COMPONENT

(30) Priorité: 13.06.2006 FR 0652117
(43) Date de publication de la demande: 04.03.2009
(73) Titulaire: Valéo Equipements Electroniques Moteur, 94000 Créteil (FR)
(72) Inventeur: MORELLE, Jean-Michel, F-45190 Beaugency (FR); VIVET, Laurent, F-78390 Bois d'Arcy (FR); ROULEAU, Blaise, 92140 Clamart (FR)
(86) Numéro de dépôt international: PCT/FR2007/051429
(87) Numéro de publication internationale: WO 2007/144539

(56) Documents cités:
- FR-A1- 2 862 424
- US-A- 4 339 768

## Description

La présente invention concerne un support pour composant électrique et un dispositif électrique comprenant le support et le composant électrique.

Elle s'applique plus particulièrement à un support sur lequel on assemble un composant électrique, par exemple une pastille semi-conductrice, par soudage avec ou sans apport de matière.

On connaît déjà, dans l'état de la technique, un support pour composant électrique comprenant une partie métallique conductrice, destinée à être chauffée pour l'assemblage du composant électrique sur la partie métallique, et une partie en matériau synthétique, jointive avec la partie métallique, assurant la cohésion du support, comprenant une masse de basse température de fusion. Le document US 4 339 768 A décrit un support pour composant électrique comprenant une partie métallique et une partie en matériau synthétique.

Généralement, la masse de basse température de fusion est formée, notamment pour des raisons économiques, dans un matériau peu résistant à la chaleur, ayant une température de fusion relativement basse, inférieure à 200°C.

Afin d'assembler le composant par soudage, avec ou sans apport de matière, il est nécessaire de chauffer la partie métallique au droit du composant à une température de soudage pouvant atteindre localement 300°C par exemple.

Par conséquent, afin de protéger la partie en matériau synthétique d'une élévation de température trop importante, il est nécessaire de prévoir une distance de sécurité suffisante entre la partie en matériau synthétique et le composant soudé sur la partie métallique.

De ce fait, une partie relativement importante de la masse de la partie métallique n'est utile que lors de l'assemblage du composant et augmente l'encombrement du support et du dispositif électrique comprenant ce support.

L'invention a notamment pour but de proposer un support pour composant électrique dans lequel les dimensions de la partie métallique sont relativement réduites, ceci sans risque d'endommagement de la partie en matériau synthétique lors de l'assemblage du composant sur le support.

A cet effet, l'invention a pour objet un support du type précité, caractérisé en ce que la partie en matériau synthétique comprend une masse de haute température de fusion, intercalée entre la masse de basse température de fusion et la partie métallique et réalisée dans un matériau ayant une température de fusion supérieure à la température de fusion de la masse de basse température de fusion.

Comme la masse de haute température de fusion a une température de fusion supérieure à la masse de basse température de fusion, il est possible de réduire, voire annuler, la distance de sécurité entre le composant et la partie en matériau synthétique. Une réduction de cette distance permet une réduction des dimensions du dispositif électrique.

Par ailleurs, même si le matériau de la masse de haute température de fusion est plus coûteux que le matériau de la masse de basse température de fusion, la réduction de la masse totale de la partie en matériau synthétique et de la partie métallique permet de compenser au moins partiellement le coût supplémentaire relatif à l'utilisation d'un matériau plus coûteux.

Un support selon l'invention peut en outre comporter l'une ou plusieurs des caractéristiques suivantes :
- le matériau de la masse de haute température de fusion est choisi parmi du polyétheréthercétone, du polyétheréthercétone haute température et du polymère cristal liquide ;
- le matériau de la masse de basse température de fusion est choisi parmi du polysulfure de phénylène et du terphényle polybromé ;
- la masse de haute température de fusion est surmoulée sur la partie métallique ;
- la masse de basse température de fusion est surmoulée sur la masse de haute température de fusion.

L'invention a encore pour objet un dispositif électrique comprenant un support et un composant électrique assemblé sur le support, caractérisé en ce que le support est un support selon l'invention.

Un dispositif électrique selon l'invention peut en outre comporter l'une ou plusieurs des revendications suivantes :
- le composant électrique est soudé sur la partie métallique du support avec apport de matière ;
- le composant électrique est soudé sur la partie métallique du support sans apport de matière.

L'invention sera mieux comprise à la lecture de la description qui va suivre, donnée uniquement à titre d'exemple et faite en se référant aux dessins annexés dans lesquels :
- la figure 1 est une vue en coupe d'un dispositif électrique selon l'invention ;
- la figure 2 est une vue en coupe du dispositif de la figure 1, illustrant une étape d'assemblage d'un composant électrique sur un support selon l'invention.

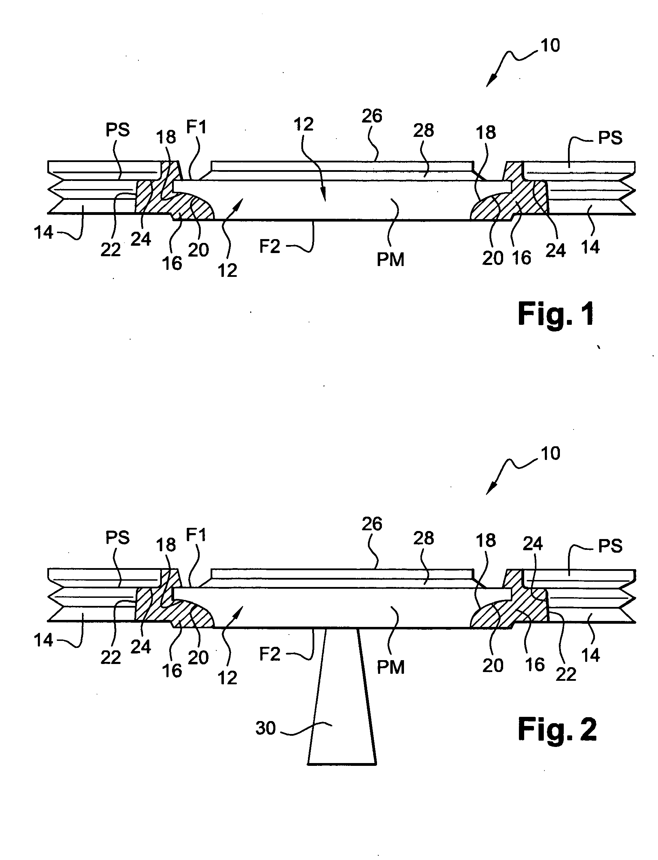

On a représenté sur la figure 1 un dispositif électrique selon l'invention. Le dispositif est désigné par la référence générale 10.

Ce dispositif 10 comprend un support 12 ayant une forme générale de plaque.

En particulier, le support 12 comprend une partie métallique PM conductrice et une partie en matériau synthétique PS, jointive avec la partie métallique PM, assurant la cohésion du support 12.

La partie métallique PM et la partie en matériau synthétique PS sont délimitées par des faces opposées du support 12.

Le matériau dans lequel est réalisé la partie métallique PM peut comprendre par exemple du cuivre ou du fer.

La partie en matériau synthétique PS comprend une masse 14 de basse température de fusion. La température de fusion de la masse 14 est de l'ordre, par exemple, de 200°C.

Le matériau de la masse de basse température de fusion 14 est, par exemple, choisi parmi du polysulfure de phénylène (acronyme anglais : PPS) et du terphényle polybromé (acronyme anglais : PBT).

Par ailleurs, la partie en matériau synthétique PS comprend encore une masse 16 de haute température de fusion, intercalée entre la masse de basse température de fusion 14 et la partie métallique PM.

Plus particulièrement, la masse de haute température de fusion 16 est réalisée dans un matériau ayant une température de fusion supérieure à la température de fusion de la masse de basse température de fusion 14. Par exemple, la température de fusion de la masse de haute température de fusion 16 est de l'ordre de 300°C.

De préférence, la masse de haute température de fusion 16 est réalisée dans un matériau choisi parmi du polyétheréthercétone (acronyme anglais : PEEK), du polyétheréthercétone haute température (acronyme anglais : PEEK HT) et du polymère cristal liquide (acronyme anglais : LCP).

La partie métallique PM est délimitée par un bord 18 de jonction avec la partie en matériau synthétique PS, plus particulièrement avec un premier bord 20 de la masse de haute température de fusion 16.

La masse de basse température de fusion 14 est délimitée par un bord 22 de jonction avec un deuxième bord 24 de la masse de haute température de fusion 16.

Les bords 18 et 20 de jonction avec les premier et deuxième bords 22 et 24 de la masse de haute température de fusion 16 s'étendent entre les faces opposées du support 12.

De façon avantageuse, la masse de haute température de fusion 16 est surmoulée sur le bord de jonction 18 de la partie métallique PM et la masse de basse température de fusion 14 est surmoulée sur le bord 24 de la masse de haute température de fusion 16.

Dans l'exemple décrit, les bords 18 et 20 ainsi que les bords 22 et 24 ont des formes générales de feuillures complémentaires.

Le dispositif électrique 10 comprend encore un composant électrique 26, par exemple du type pastille semi-conductrice, assemblé sur une première face F1 de la partie métallique PM.

Dans l'exemple décrit, le composant 26 est soudé sur la partie métallique PM du support 12 avec apport de matière. A cet effet, on voit sur la figure 1 qu'une masse 28 de brasure est intercalée entre le composant 26 et la première face F1 de la partie métallique PM.

La masse 28 de brasure peut éventuellement être formée par un revêtement (non représenté) de la première face F1 de la partie métallique PM, solidaire de la partie métallique PM avant le brasage, le matériau du revêtement pouvant être par exemple du nickel.

En variante, le composant 26 est soudé sans apport de matière sur la première face F1 de la partie métallique PM.

La figure 2 illustre l'étape de brasage du composant 26 sur le support 12 conformément à un procédé de brasage classique.

Ainsi, afin de faire fondre la masse de brasure 28, on chauffe la partie métallique PM au droit du composant 26 par exemple par irradiation par un faisceau laser 30 d'une deuxième face F2 de la partie métallique PM opposée à la première face F1.

En variante, on chauffe la partie métallique PM au droit du composant 26 avec une thermode ou une micro-flamme.

La chaleur se propage alors dans la partie métallique PM et atteint notamment la partie en matériau synthétique PS.

Comme la partie en matériau synthétique PS comprend une masse de haute température de fusion 16 intercalée entre la masse de basse température de fusion 14 et la partie métallique PM, la masse de basse température de fusion 14 ne risque pas d'être endommagée par une élévation trop importante de température.

En réalisant la masse de haute température de fusion 16 dans un matériau de température de fusion supérieure à la température de fusion de la masse de brasure 28, il est possible de réduire la distance de sécurité prévue entre la masse de haute température de fusion 16 et le composant électrique 26 et ainsi de réduire la masse de la partie métallique PM.

L'invention permet alors, en réduisant la masse de la partie métallique PM, de réduire la masse de la partie en matériau synthétique PS, et ainsi la masse du dispositif électrique 10.

## Revendications

1. Support (12) pour composant électrique (26) comprenant une partie métallique (PM) conductrice et une partie en matériau synthétique (PS), jointive avec la partie métallique (PM), assurant la cohésion du support (12), comprenant une masse présentant une première température de fusion, dite de basse température de fusion (14), **caractérisé en ce que** la partie en matériau synthétique (PS) comprend une masse présentant une deuxième température de fusion, dite de haute température de fusion (16), intercalée entre la masse de basse température de fusion (14) et la partie métallique (PM) et réalisée dans un matériau ayant une température de fusion supérieure à la température de fusion de la masse de basse température de fusion (PS).

2. Support (12) selon la revendication 1, dans lequel le matériau de la masse de haute température de fusion (16) est choisi parmi du polyétheréthercétone, du polyétheréthercétone haute température et du polymère cristal liquide.

3. Support (12) selon la revendication 1 ou 2, dans lequel le matériau de la masse de basse température de fusion (14) est choisi parmi du polysulfure de phénylène et du terphényle polybromé.

4. Support (12) selon l'une quelconque des revendications 1 à 3, dans lequel la masse de haute température de fusion (16) est surmoulée sur la partie métallique (PM).

5. Support (12) selon la revendication 4, dans lequel la masse de basse température de fusion (14) est surmoulée sur la masse de haute température de fusion (16).

6. Dispositif électrique (10) comprenant un support (12) et un composant électrique (22) assemblé sur le support (12), **caractérisé en ce que** le support (12) est un support selon l'une quelconque des revendications 1 à 5.

7. Dispositif électrique (10) selon la revendication 6, dans lequel le composant électrique (22) est assemblé sur la partie métallique (PM) du support (12) à l'aide d'une soudure réalisée avec apport de matière.

8. Dispositif électrique (10) selon la revendication 6, dans lequel le composant électrique (22) est assemblé sur la partie métallique (PM) du support (12) à l'aide d'une soudure sans apport de matière.

## Claims

1. Holder (12) for an electrical component (26) comprising a conductive metallic part (PM) and a part (PS) made of a synthetic material, contiguous with the metallic part (PM), ensuring the cohesion of the holder (12), comprising a mass that has a first melting point, known as the low melting point (14), **characterized in that** the part (PS) made of synthetic material comprises a mass having a second melting point, known as the high melting point (16), interposed between the low melting point mass (14) and the metallic part (PM) and made of a material that has a melting point higher than the melting point of the low melting point mass (PS).

2. Holder (12) according to Claim 1, in which the material of the high melting point mass (16) is chosen from polyether ether ketone, high-temperature polyether ether ketone and liquid crystal polymer.

3. Holder (12) according to Claim 1 or 2, in which the material of the low melting point mass (14) is chosen from polyphenylene sulphide and polybrominated terphenyl.

4. Holder (12) according to any one of Claims 1 to 3, in which the high melting point mass (16) is overmoulded onto the metallic part (PM).

5. Holder (12) according to Claim 4, in which the low melting point mass (14) is overmoulded onto the high melting point mass (16).

6. Electrical device (10) comprising a holder (12) and an electrical component (22) assembled onto the holder (12), **characterized in that** the holder (12) is a holder according to any one of Claims 1 to 5.

7. Electrical device (10) according to Claim 6, in which the electrical component (22) is assembled onto the metallic part (PM) of the holder (12) using a weld that involves the addition of a filler material.

8. Electrical device (10) according to Claim 6, in which the electrical component (22) is assembled onto the metallic part (PM) of the holder (12) using a weld that does not involve the addition of a filler material.

## Patentansprüche

1. Träger (12) für elektrisches Bauteil (26), der ein leitendes Metallteil (PM) und ein Kunststoffteil (PS), das an das Metallteil (PM) angrenzt und den Zusammenhalt des Trägers (12) gewährleistet und eine Masse enthält, die eine erste Schmelztemperatur besitzt, die niedrige Schmelztemperatur (14) genannt wird, umfasst, **dadurch gekennzeichnet, dass** das Kunststoffteil (PS) eine Masse enthält, die eine zweite Schmelztemperatur, die hohe Schmelztemperatur (16) genannt wird, besitzt, die zwischen die Masse mit niedriger Schmelztemperatur (14) und das Metallteil (PM) eingefügt ist und aus einem Material verwirklicht ist, das eine Schmelztemperatur höher als die Schmelztemperatur der Masse mit niedriger Schmelztemperatur (PS) hat.

2. Träger (12) nach Anspruch 1, wobei das Material der Masse mit hoher Schmelztemperatur (16) aus Polyetheretherketon, Hochtemperatur-Polyetheretherketon und Flüssigkristallpolymer gewählt ist.

3. Träger (12) nach Anspruch 1 oder 2, wobei das Material der Masse mit niedriger Schmelztemperatur (14) aus Phenylen-Polysulfid und polybromierten Terphenyl gewählt ist.

4. Träger (12) nach einem der Ansprüche 1 bis 3, wobei die Masse mit hoher Schmelztemperatur (16) auf das Metallteil (PM) gegossen ist.

5. Träger (12) nach Anspruch 4, wobei die Masse mit niedriger Schmelztemperatur (14) auf die Masse mit hoher Schmelztemperatur (16) gegossen ist.

6. Elektrische Vorrichtung (10), die einen Träger (12) und ein auf dem Träger (12) angebrachtes elektrisches Bauteil (22) umfasst, **dadurch gekennzeichnet, dass** der Träger (12) ein Träger nach einem der Ansprüche 1 bis 5 ist.

7. Elektrische Vorrichtung (10) nach Anspruch 6, wobei das elektrische Bauteil (22) auf dem Metallteil (PM) des Trägers (12) mit Hilfe einer mit Materialeintrag ausgeführten Schweißung angebracht ist.

8. Elektrische Vorrichtung (10) nach Anspruch 6, wobei das elektrische Bauteil (22) auf dem Metallteil (PM) des Trägers (12) mit Hilfe einer Schweißung ohne Materialeintrag angebracht ist.
